# FASCICULE DE BREVET EUROPEEN

(11) **EP 2 882 052 B1**
(45) Date de publication et mention de la délivrance du brevet: **27.11.2019**
(21) Numéro de dépôt: 14187786.0
(22) Date de dépôt: 06.10.2014
(51) Int. Cl.: H02B 1/56, H02B 7/06, H01F 27/08, H02M 7/00, H05K 7/20

(54) **Régulation thermique d'un compartiment d'un poste électrique d'alimentation portuaire**
Wärmeregulierung des Kastens einer elektrischen Schaltanlage in einem Hafen
Heat regulation of a compartment in a port electrical power supply substation

(30) Priorité: 18.11.2013 FR 1361273; 18.11.2013 FR 1361274
(43) Date de publication de la demande: 10.06.2015
(73) Titulaire: Schneider Electric Industries SAS, 92500 Rueil-Malmaison (FR)
(72) Inventeur: Cormenier, Thierry, 38050 Grenoble Cedex 09 (FR); Moreau, Julien, 38050 Grenoble Cedex 09 (FR)
(74) Mandataire: Tripodi, Paul

(56) Documents cités:
- EP-A1- 2 498 588
- EP-A2- 1 026 932
- WO-A1-2005/055384
- CN-U- 202 268 639
- DE-A1-102011 001 786
- DE-A1-102011 106 632
- JP-A- H08 205 330
- JP-A- 2009 076 825
- JP-U- S57 133 212
- KR-B1- 101 328 069

## Description

### DOMAINE TECHNIQUE

L'invention concerne la régulation thermique des postes d'alimentation des bateaux à quai par le réseau de distribution électrique terrestre, lesdits postes pouvant assurer une conversion de fréquence, notamment de 50 à 60 Hz et étant logés dans une enceinte métallique.

En particulier, l'invention est relative à un compartiment de conversion de fréquence ou à un compartiment de transformation de tension d'un tel poste et aux éléments permettant ladite régulation.

### ETAT DE LA TECHNIQUE

Bien qu'à l'origine les navires aient été équipés de réseaux électriques basse tension, comme les besoins en puissance ont considérablement augmenté, les réseaux électriques mis en œuvre sur les navires sont généralement du type moyenne tension, ce qui permet d'utiliser des câbles de section moins importante et de réduire les pertes énergétiques dans l'alimentation des réseaux des navires.

Lorsqu'un navire est à quai, afin de pouvoir arrêter son groupe électrogène, il lui faut disposer d'une installation dans le port permettant l'alimentation électrique de ses équipements avec une source d'énergie adéquate. La puissance requise peut être importante, de 1 MVA jusqu'à 20 MVA selon qu'il s'agit d'un vraquier, d'un ferry, d'un porte-conteneurs, d'un paquebot,... sous des tensions différentes, notamment 6,6 kV ou 11 kV selon les normes IEC 80005-1 ; de plus les navires présentent, selon leur type, des équipements électriques fonctionnant en 50 ou en 60 Hz. Par ailleurs, les navires requérant, avec des contraintes variables selon leur type, une bonne continuité de l'alimentation en énergie électrique pendant qu'ils sont à quai, l'alimentation portuaire doit être continue, même après défaut. En outre, les installations d'alimentation à quai subissent les contraintes inhérentes à leur emplacement, par définition à proximité d'eau, souvent salée. Qui plus est, les ports souhaitent des installations aussi compactes que possible.
Pour éviter de lourds travaux de génie civil, des postes électriques métalliques modulaires ont été développés, dans lesquels l'ensemble des équipements est pré-eâblé et qui sont segmentés pour le transport sur le site où ne sont réalisés que les derniers raccordements : voir par exemple FR2 972 576. Tel qu'illustré en figure 1, le poste métallique 10 permet de convertir une première tension électrique de puissance d'entrée, fournie par un réseau 12, en une deuxième tension électrique de puissance de sortie destinée à alimenter un réseau électrique de navire 14, qui peut être de fréquence et/ou de tension différente.
Par exemple, le brevet JP H08 205330 A décrit un poste effectuant une conversion de fréquence. Les documents JP S57 133212U ou JP H 08 205330 A décrivent des dispositifs de refroidissement d'armoire électrique. Le document EP 2 498 588 A1 décrit un procédé de gestion thermique d'une enceinte comportant un premier compartiment comportant un convertisseur de tension et un deuxième compartiment comportant un dispositif d'électronique de puissance. Les documents DE 10 2011 106632 A1 et DE 10 2011 001786 A1 décrivent une armoire électrique comportant plusieurs compartiments occupés par des modules de puissance disposant d'un dispositif de refroidissement.
Pour couvrir les différentes options suivant les navires à quai, le poste comprend ainsi quatre compartiments, ou éléments fonctionnels, regroupant les appareillages électriques assurant une fonction définie de l'installation de conversion :
- un compartiment 20 de contrôle et de commande du poste 10 ainsi que de contrôle et protection de la moyenne tension, ledit compartiment 20 comprenant notamment des éléments de protection de type disjoncteurs 25 ;
- un compartiment 100 de transformation de la moyenne tension d'entrée vers la basse tension, comprenant notamment un transformateur 105 ;
- un compartiment 200 comprenant des moyens de conversion de fréquence 205, de préférence des convertisseurs de fréquences réseau, ou GFC pour « Grid Frequency Converter » ;
- un compartiment 100' pour la fourniture de l'alimentation avec un transformateur de tension 105'.
Pour protéger des équipements aussi sensibles, dans un environnement aussi contraint, on utilise généralement des enceintes climatisées, étanches à l'environnement externe.

Cependant, si le premier compartiment 20 est de préférence hermétique et climatisé, cette solution s'avère onéreuse, et nécessite en outre une maintenance accrue pour s'assurer de la fiabilité des installations pour les autres compartiments. De fait, la norme CEI 62271-202 préconise une ventilation naturelle pour les appareils de transformation de tension 105 : une entrée d'air en position basse et une sortie d'air en position haute associées à réchauffement de l'air par l'appareil en fonctionnement assurent ainsi une convection naturelle et un renouvellement d'air de plusieurs mètres cube par heure. Pour augmenter le refroidissement, notamment en période estivale, la ventilation peut être forcée en complément par un dispositif de circulation d'air qui peut être actionné ou non selon un paramètre choisi tel que la température, pour supprimer les crêtes de point chaud.
Les GFC 205 quant à eux ne possèdent pas de régulation interne de température, ni de protection contre la condensation : hormis les cas climatisés, ils sont placés dans des logements avec une ventilation naturelle, éventuellement forcée, parfois associée à un chauffage du compartiment pour diminuer l'humidité relative de l'air. En particulier, les convertisseurs de fréquence 205 intègrent généralement des caloducs qui gèlent en cas de température négative : un contrôle de température avant même le démarrage pour placer les équipements dans de bonnes conditions est donc souhaitable. Le compartiment dédié 200 peut ainsi mettre en œuvre un contrôle de la température indépendant actionnant ou non la ventilation dédiée.
Cependant, compte tenu de la dépression relative entre compartiments générée par une ventilation forcée et des fuites inévitables, il faut s'assurer que des circulations parasites ne viennent pas perturber le fonctionnement global.
Par ailleurs, le poste 10 étant installé en milieu portuaire, il est indispensable de protéger les équipements électriques de l'environnement externe, notamment l'air salin : des filtres adaptés sont placés sur les entrées d'air. Or ce type de filtre est très coûteux à remplacer ; pour réduire leur encrassement et donc les coûts de maintenance, il est souhaitable d'optimiser le débit d'air d'une ventilation forcée notamment.
Il apparaît ainsi que le contrôle de la ventilation et de la température dans un poste d'alimentation portuaire peut être amélioré.

### EXPOSE DE L'INVENTION

Parmi autres avantages, l'invention vise à pallier des inconvénients des postes d'alimentation à quai existants, en proposant un système de régulation de la ventilation des compartiments de ce type de poste, ledit système prenant en compte les différents paramètres. Du fait de la régulation et de l'optimisation de la ventilation qui en découle, le fonctionnement des appareils électriques des compartiments du poste d'alimentation est lui aussi optimisé, ce qui permet de réaliser un poste plus compact, les appareils étant dimensionnés au plus juste des capacités demandées. De plus, cette régulation permet un moindre vieillissement des divers composants grâce à l'optimisation de leurs conditions de fonctionnement.
L'invention est ainsi relative à un compartiment de poste d'alimentation portuaire défini dans les revendications.
Il comprend une enceinte logeant un transformateur, de préférence de type sec avec trois enroulements moyenne tension et trois enroulements basse tension. L'enceinte est munie de moyens d'entrée d'air munis de filtres adaptés de préférence à l'air salin, avantageusement sous forme de deux caissons sur deux parois opposées de l'enceinte, et localisées vers le bas du poste ; l'enceinte est également munie de moyens de sortie d'air, de préférence sur le toit de l'enceinte ou sur toute partie d'extrémité haute. L'enceinte loge également des moyens de mesure de la température interne de l'enceinte, par exemple au niveau de la sortie d'air, et des moyens de mesure de la température du transformateur, de préférence trois capteurs au niveau de ses enroulements.
Pour assurer une ventilation forcée, l'enceinte est munie de moyens d'extraction d'air, logés au niveau de la sortie d'air, et de moyens de ventilation tangentielle, de préférence logés vers les entrées d'air, en dessous des enroulements du transformateur. Pour réguler la température, le compartiment comprend en outre des moyens de régulation aptes à commander la mise en marche et la vitesse des moyens d'extraction d'air et des moyens de ventilation en fonction des données de température. Notamment, les moyens de régulation comprennent des moyens pour démarrer les moyens de ventilation tangentielle lorsque l'un des capteurs de température de transformateur dépasse un premier seuil et pour les arrêter lorsque la mesure de tous les capteurs de température de transformateur est inférieure à un deuxième seuil. De préférence, si l'un des capteurs de température de transformateur dépasse un troisième seuil, supérieur au premier, les moyens de régulation comprennent un mode de secours dans lequel les moyens de ventilation tangentielle ne sont pas arrêtés après leur démarrage. Les moyens de régulation comprennent aussi des moyens pour imposer une vitesse de flux d'air en fonction de la température de l'enceinte aux moyens d'extraction lorsque ladite température dépasse une première valeur ; la première valeur peut être déterminée en fonction de la température extérieure donnée par des moyens appropriés.

L'invention concerne également un poste d'alimentation portuaire comprenant au moins un, notamment deux, compartiments précédents, et avantageusement un compartiment de conversion de fréquence. De préférence, le poste comprend une enceinte métallique avec des parois internes délimitant lesdits compartiments, et dans lequel deux compartiments avec transformateur entourent le compartiment de conversion de fréquence. Le compartiment de conversion de fréquence peut comprendre des moyens de ventilation forcée, et les moyens de régulation des compartiments de transformateur peuvent alors comprendre des moyens pour démarrer les moyens d'extraction dudit compartiment lorsqu'un signal de détection de la ventilation forcée du compartiment de conversion de fréquence lui parvient.

Dans un mode de réalisation préférentiel, l'invention concerne un compartiment de poste d'alimentation portuaire comprenant une enceinte logeant des moyens de conversion de fréquence, de préférence sous la forme d'une pluralité de convertisseurs de fréquence réseau ou GFC. L'enceinte est munie de moyens d'entrée d'air munis de filtres adaptés de préférence à l'air salin, avantageusement sous forme de caissons sur deux parois opposées de l'enceinte, et localisées vers le bas du poste ; l'enceinte est également munie de moyens de sortie d'air, de préférence sur le toit de l'enceinte ou sur toute partie d'extrémité haute. L'enceinte loge également des moyens de mesure de la température interne de l'enceinte, un dispositif de chauffage, et de préférence des moyens de mesure du degré d'humidité au sein de l'enceinte.

Pour assurer une ventilation forcée, l'enceinte est munie de moyens d'extraction d'air, logés au niveau de la sortie d'air, et de moyens de ventilation des moyens de conversion, de préférence associés à chacun des GFC, notamment en faisant partie intégrante. Pour contrôler la température, le compartiment comprend en outre des moyens de régulation aptes à commander la vitesse des moyens d'extraction d'air et des moyens de ventilation en fonction des données de température, et accessoirement de degré d'humidité.

Le compartiment comprend en outre des moyens pour vérifier les conditions environnementales à l'intérieur de l'enceinte et pour démarrer les moyens de conversion lorsque ces conditions sont remplies. Parmi les conditions environnementales se trouve la vérification que la température dépasse une limite inférieure, et que le degré d'humidité est suffisamment faible. Les moyens de vérification sont de préférence associés aux moyens de régulation.

Notamment, les moyens de régulation comprennent des moyens pour démarrer le dispositif de chauffage lorsque la température est inférieure à une première valeur, ainsi que lorsque le degré d'humidité est supérieur à un seuil et la température inférieure à une deuxième valeur. Les moyens de régulation comprennent également des moyens pour démarrer les moyens de ventilation lorsque le degré d'humidité est supérieur audit seuil, et la température supérieure à la deuxième valeur.

Les moyens de régulation comprennent également des moyens pour démarrer les moyens d'extraction lorsque la température est supérieure à une valeur limite, et pour imposer, lorsque les moyens de conversion sont en fonctionnement, une vitesse auxdits moyens dépendant de la température interne, ainsi éventuellement que de la température externe et/ou de la puissance dissipée.

L'invention concerne également un poste d'alimentation portuaire comprenant au moins un tel compartiment et des compartiments logeant des transformateurs de tension, de préférence qui l'entourent, les différents compartiments étant avantageusement logés dans une même enceinte métallique et séparés par des parois interne de l'enceinte.

L'invention se rapporte enfin à un procédé de régulation thermique d'un compartiment de conversion de fréquence d'un poste d'alimentation portuaire lorsque la conversion est en fonctionnement. Le procédé comprend la détermination de la température interne au compartiment, l'actionnement de moyens d'extraction d'air lorsque la température dépasse une valeur limite et la régulation de la vitesse desdits moyens d'extraction en fonction de la température interne, ainsi qu'éventuellement la température extérieure et/ou la puissance dissipée. Le procédé de régulation thermique est de préférence précédé d'une phase de vérification des conditions environnementales au sein du compartiment avant mise en fonctionnement des moyens de conversion de fréquence, ladite phase comprenant :
- la détermination de la température et du degré d'humidité internes au compartiment,
- le chauffage du compartiment lorsque la température est inférieure à une première valeur, le chauffage étant maintenu pendant une certaine durée après que la première valeur a été atteinte,
- la mise en œuvre de moyens de diminution du degré d'humidité lorsqu'il est supérieur à un seuil, notamment par chauffage lorsque la température est inférieure à une deuxième valeur et par actionnement de ventilateurs lorsque la température est supérieure à la deuxième valeur, les moyens de diminution étant maintenus pendant une certaine durée après que le seuil a été atteint,
- l'actionnement pendant une troisième durée des ventilateurs une fois les conditions remplies, puis
- la mise en fonctionnement des moyens de conversion de fréquence.

Dans un mode de réalisation préféré, lorsque la durée entre la ventilation et la mise en fonctionnement dépasse une durée prédéterminée, le procédé de régulation comprend le maintien des conditions environnementales en mettant en œuvre le chauffage, la ventilation ou l'extraction d'air en fonction de la température et du degré d'humidité.

### BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.
La figure 1, déjà décrite, illustre le principe d'un poste d'alimentation portuaire dans lequel les modes de réalisation de l'invention peuvent être implémentés.
La figure 2 montre un poste d'alimentation portuaire selon un mode de réalisation préféré de l'invention.
La figure 3 représente la ventilation dans un compartiment de transformation de tension pour un poste selon un mode de réalisation préféré de l'invention.
La figure 4 montre le procédé de régulation de la température dans un compartiment de transformation de tension pour un poste selon un mode de réalisation préféré de l'invention.
La figure 5 représente un compartiment de conversion de fréquence pour un poste selon un mode de réalisation préféré de l'invention.
Les figures 6A et 6B montrent la régulation mise en œuvre dans un compartiment de conversion de fréquence pour un poste selon un mode de réalisation préféré de l'invention

### DESCRIPTION DETAILLEE D'UN MODE DE REALISATION PREFERE

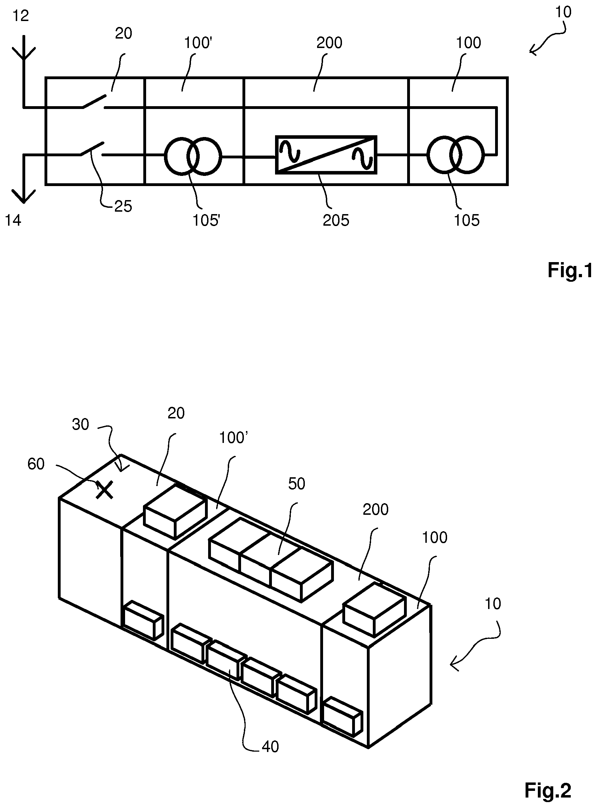

Tel qu'indiqué, un poste d'alimentation 10 à quai selon un mode de réalisation préféré de l'invention est composé d'une enceinte métallique 30 disposant de quatre compartiments séparés par des parois internes. Tel qu'illustré en figure 2, trois des compartiments du poste 10 comprennent des moyens de ventilation naturelle, le quatrième 20 étant étanche. Les moyens de ventilation naturelle comprennent des moyens d'entrée d'air 40, situés vers le bas du conteneur 30, et des moyens de sortie d'air 50 vers le haut, de préférence sous forme de cheminée ou tourelle.

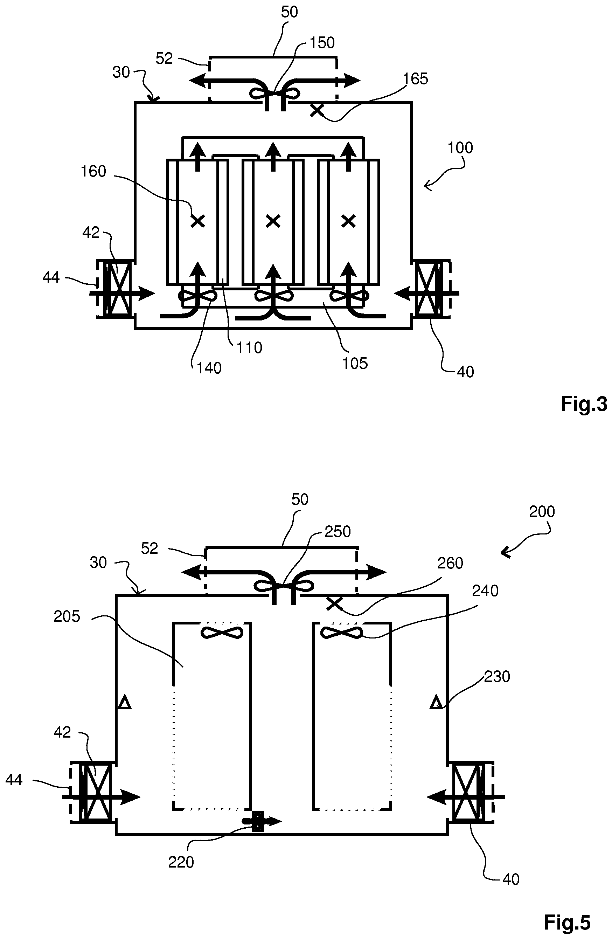

Les moyens d'entrée d'air sont sous forme caissons de ventilation 40 situés en partie basse de deux parois opposées du conteneur 30 communes à tous les compartiments 20, 100, 200, qui incluent de préférence (voir figures 3 et 5) des filtres 42 adaptés à l'air salin (pré filtre + filtre final), et une grille 44 garantissant un degré de protection supérieur à la valeur minimale imposée par la norme CEI 62271-202, notamment contre les impacts mécaniques d'une valeur de 20 joules, ou conformément à un IP23D selon la norme CEI 60529. Le nombre de caissons 40, de taille habituellement standardisée, est déterminé par le débit d'air nécessaire pour assurer le refroidissement des appareils contenus dans chaque compartiment 100, 200, 100', et la place disponible ; en particulier, tel que schématisé pour un poste 10 de 3 MVA, un caisson 40 est localisé sur les deux faces opposées d'un compartiment de transformation de tension 100, alors que le compartiment plus long de conversion de fréquence 200, comprenant 6 GFC, est doté de deux fois quatre caissons 40.

Les moyens de sortie d'air 50 sont quant à eux munis d'une hotte de toiture avec des grilles 52 permettant de garantir les indices de protection contre la pénétration de solide et liquide IP et contre les chocs IK imposés par la norme CEI 62271-202 ; éventuellement, une vantelle de surpression permet d'améliorer la protection face aux conditions de services externes lorsque l'installation est arrêtée. Le nombre de sorties d'air 50 dépend de l'efficacité du flux d'air requise : il est ainsi préféré de disposer de plusieurs tourelles sur le compartiment « long » de conversion de fréquence 200, trois doubles dans le mode de réalisation illustré, plutôt qu'une large cheminée.

Un compartiment de transformation de tension 100 comprend ainsi, tel qu'illustré en figure 3, une enveloppe métallique 30 avec deux entrées d'air 40 munies de filtres 42 et une tourelle 50 de sortie d'air qui loge un transformateur de tension 105 de type sec, choix permettant de mieux satisfaire les dispositions réglementaires contre les incendies en environnement portuaire. Du fait de la ventilation filtrée qui ne génère pas de dépôt de sel, le transformateur 105 peut être de type « papier » traditionnel, sans protection particulière de l'enroulement basse tension, et il n'est pas nécessaire d'utiliser un transformateur à protection renforcée « double cast », à résine, plus lourd, plus gros et plus onéreux.

Selon l'invention, la ventilation du transformateur 105 est réalisée de façon contrôlée. Comme les compartiments de transformation de tension 100 entourent un compartiment de conversion de fréquence 200 dont les appareils sont sensibles, il convient de ne pas transmettre d'air, ou le moins possible, en minimisant la quantité d'air passant à travers les parois internes de l'enceinte 30 entre compartiments 100, 200 : un flux par dépression d'air est donc choisi, avec des moyens d'extraction d'air 150 de type ventilateur centrifuge avec variation de vitesse intégrée placés en sortie dans la tourelle 50 plutôt qu'une soufflerie. Par ailleurs, selon l'invention, le transformateur 105 est « boosté », c'est-à-dire qu'il est utilisé dans des conditions extrêmes ; en particulier, la capacité théorique du transformateur 105 est augmentée. A cette fin, le flux d'air est dirigé de façon laminaire le long des enroulements 110 grâce à la présence de dispositifs de ventilation radiaux ou tangentiels 140 localisés sous les enroulements 110 du transformateur 105, afin de diriger le flux ; le débit desdits dispositifs de ventilation 140 est sensiblement inférieur au débit de l'extracteur 150 afin de conserver un flux laminaire.

En particulier, tel qu'illustré en figure 3, des ventilateurs tangentiels 140 sont mis en place de chaque côté en bas du transformateur 105 ; couplés à la force motrice du flux générée par l'extracteur 150 et dimensionnés pour équilibrer ladite force, le flux principal d'air est relayé dans les enroulements 110 avec de l'air dépourvu d'impuretés telles que du sel ou des poussières grâce au filtre 42 protégé lui-même par les grilles 44 des caissons d'entrée d'air 40. Le transformateur 105 est légèrement surélevé par rapport au fond du poste 10 afin de s'assurer que l'air poussé dans les enroulements 110 est aspiré le plus directement possible depuis les caissons de filtration 40. L'air est expulsé au travers des grilles de sortie 52 installées sur la tourelle ou caisson de toiture 50. Par cette configuration, il est ainsi possible d'utiliser un transformateur 105 de la moyenne vers la basse tension d'une capacité nominale de 3 MVA jusque 3,3 MVA (l'absence de dispositifs de ventilation tangentielle ramènerait cette capacité nominale à une valeur efficace en ventilation naturelle de 2,5 MVA), et ainsi d'accroitre sa puissance disponible sans réduire sa durée de vie - le même type de résultat est bien entendu obtenu pour le transformateur 105' de la basse vers la moyenne tension.

Ce système de flux, même avec quelques fuites possibles avec le compartiment adjacent 200, n'entraîne pas de perturbation de la performance globale de la solution, et ne perturbe pas non plus le refroidissement des locaux de convertisseurs de fréquences basés sur le même principe.

Pour optimiser encore le dimensionnement du transformateur 105, et ainsi permettre la mise en place d'un poste d'alimentation 20 plus compact et moins onéreux, un contrôle de la température est couplé à la ventilation du transformateur 105, avec notamment une régulation contrôlée. A cette fin, le compartiment de transformation 100 est équipé en outre de trois capteurs de température 160 dans les enroulements BT 110 et un capteur de température 165 localisé à proximité de la sortie d'air 50.

Notamment, la température ambiante interne au compartiment 100 est mesurée par le capteur de sortie 165. Lorsque ladite température T₁₀₀ dépasse un seuil T_{100_ref}, par exemple fixé à 35°C, l'extracteur d'air 150 est mis en route. De préférence, la vitesse de l'extracteur V₁₅₀ est ajustée en fonction de la température, par exemple selon une loi linéaire, pour maintenir T₁₀₀ = T_{100_ref} : le débit d'air peut ainsi être réglé au strict nécessaire grâce au capteur de sortie 165 situé dans le flux d'air, ce qui permet de diminuer l'encrassement des filtres 42. Si le poste d'alimentation 10 possède des moyens de mesure de la température extérieure 60, selon une option préférée de réalisation, le seuil T_{100_ref} est ajusté en fonction de la température extérieure Tₑₓₜ : par exemple T_{100_ref} est égale à Tₑₓₜ + T_{100_gap} tout en restant dans tous les cas supérieure à une température minimale de référence T_{100_ref_min}

Par ailleurs, lors de la réalisation du poste 10 selon l'invention, il a été constaté que les modèles de protection thermique basés sur l'image du courant ne sont pas adaptés pour des transformateurs 105 en ventilation forcée : les capteurs de température 160 intégrés aux enroulements 110 du transformateur 105 sont ainsi mis en place pour réguler le fonctionnement des ventilateurs tangentiels 140.

Le poste 10 comprend ainsi un automate de régulation pour le compartiment 100, par exemple localisé dans le premier compartiment 20. De préférence, cet automate est relié au relai de protection (par exemple de type SEPAM) auquel sont connectés les enroulements MT du transformateur 105, et il peut être adapté pour mettre en route et ajuster la vitesse V₁₅₀ de rotation l'extracteur d'air 150 par des moyens adéquats. Les moyens de régulation peuvent ainsi démarrer et arrêter, ainsi éventuellement qu'ajuster la vitesse V₁₄₀ de rotation des ventilateurs 140 : notamment lorsqu'un des enroulements dépasse un premier seuil T_{110_1}, par exemple de 110°C, les ventilateurs 140 sont démarrés, et arrêtés lorsque tous les enroulements 110 sont à une température inférieure à une température de fonctionnement normal, par exemple T_{110_0} = 100°C.

Avantageusement, un deuxième système de régulation est mis en place en cas de défaillance de la communication entre les composants (relai de protection et automate) : si la température T₁₁₀ mesurée au niveau des enroulements 110 dépasse un deuxième seuil T_{110_max} = 140°C, ou tout autre température définie par une norme CEI, les ventilateurs tangentiels 140 sont automatiquement mis en marche, et ne seront arrêtés que lorsque la communication sera rétablie ou manuellement par un opérateur de maintenance. De préférence, pour une température T₁₁₀ supérieure à un seuil critique, notamment T₁₁₀ > T_{110_crit} = 150°C, un déclenchement des systèmes de protection 25 a lieu et le poste 10 est arrêté.

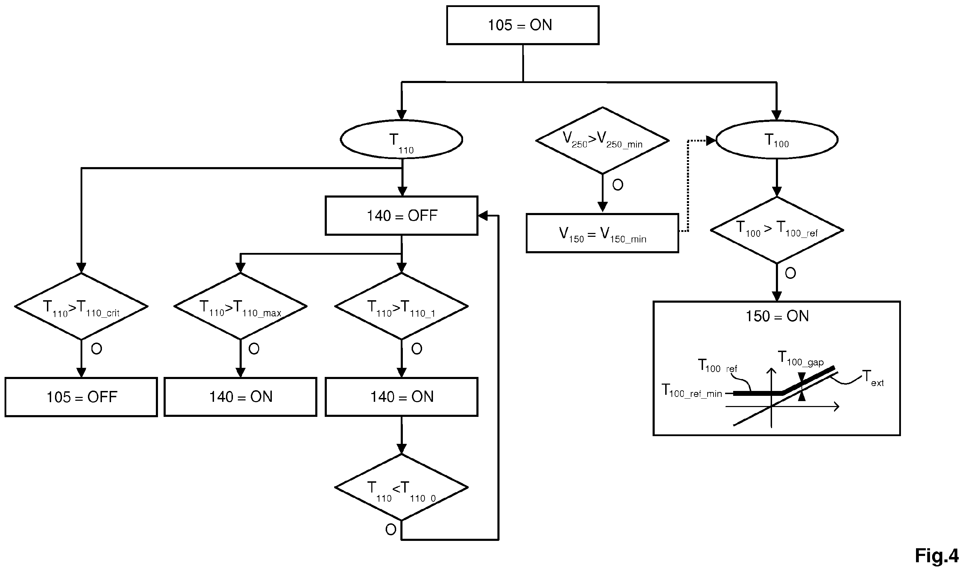

Un système de régulation préféré est schématisé en figure 4. On peut y noter une étape additionnelle de déclenchement de la ventilation forcée pour cause externe. De fait, bien que souhaitable, il est rare d'avoir une étanchéité parfaite entre les compartiments 100, 200 dans un poste d'alimentation électrique compact métallique 10. Notamment, si une ventilation forcée est mise en route dans le compartiment adjacent de conversion de fréquence 200, de l'air du compartiment de transformation de tension 100, 100' sera aspiré : la régulation selon l'invention prévoit donc un démarrage des extracteurs d'air 150 des compartiments de tension 100, 100' dès qu'une ventilation forcée est mise en route dans le compartiment adjacent 200, et un fonctionnement à vitesse faible constante V_{150_min}.

De fait, selon l'invention, des GFC sont utilisés en tant que convertisseurs de fréquence : ce type d'appareil, éprouvé, permet d'optimiser les performances en termes d'efficacité énergétique et de pollution des réseaux. Le nombre d'appareils de conversion 205 est choisi en fonction des caractéristiques du poste d'alimentation 10 ; notamment, pour un poste de 3 MVA, on utilise 6 GFC de type 500 kVA en deux rangées, alors que pour un poste de 2 MVA, on peut n'en utiliser que quatre.

Bien que possédant habituellement un ventilation intégrée 240, les GFC 205 ne comprennent pas de régulation de sorte que la ventilation fonctionne à pleine puissance quelles que soient la charge, la température et l'humidité. Il convient donc de mettre en place un système additionnel de ventilation du compartiment 200 qui comprenne des moyens de régulation tenant compte de ces variables pour garantir aux GFC 205 des conditions optimales de fonctionnement. Pour des raisons similaires de contrôle de l'orientation du flux d'air, la même solution d'extracteur 250 localisé dans la tourelle 50 est choisie ; ici encore il est préférable d'avoir des flux d'air laminaires. Les extracteurs 250 sont choisis de façon à ne pas être sollicités à leur capacité maximale pour que leur vitesse soit limitée à la puissance absorbée de 2300W, par exemple à environ 1950 tr/min.

Par ailleurs, outre les éléments présentés précédemment pour les transformateurs 105 de tension, les GFC 205 impliquent d'autres contraintes : malgré la présence des filtres 42 qui évitent l'introduction d'air marin, la condensation s'avère très problématique et il est important de vérifier que le flux d'air est suffisant pour éviter le dépôt d'humidité sur les GFC 205. De plus, si les GFC 205 peuvent être stockés avec des températures négatives, ils ne peuvent fonctionner que par des températures T₂₀₀ supérieures à 5°C en raison de l'eau présente dans les caloducs ; leur seule mise en service nécessite que l'eau puisse circuler, sous peine de destruction. Outre une régulation de la ventilation, un chauffage est donc préconisé dans le compartiment de conversion de fréquence 200 ; différents moyens sont possibles, notamment avec la présence d'un dispositif de chauffage 220 dédié, dont la puissance peut être optimisée (en première approche, pour un poste 3 MVA, un appareil 220 de type 2 x 3 x 2 kW est utilisé, et un appareil de type 2 x 2 x 2 kW pour 2 MVA). Ce type de monitorage peut naturellement être utilisé dans le compartiment transformateur 100 mais s'avère inutile, notamment avec des transformateurs secs, insensibles à la température et/ou la présence de condensation « naturelle » (hors air salin).

La régulation de la ventilation d'un poste 10 selon l'invention prévoit donc, pour le compartiment GFC 200, un chauffage permettant de préférence de :
- conserver une température T₂₀₀ positive entre deux raccordements à des navires pour utilisation ;
- augmenter la température T₂₀₀ jusqu'un minimum de 5°C après une défaillance du réseau ou un arrêt total volontaire, afin de démarrer les GFC 205 ;
- éviter la condensation dans le compartiment 200, notamment lorsque la température est basse.
De fait, la condensation dans le compartiment peut être évitée par deux principes : le chauffage ou la ventilation interne des GFC 205 qui peuvent être pilotés par la régulation du poste 10. Selon un mode de réalisation préféré, lorsque la température ambiante T₂₀₀ est basse, par exemple inférieure à T_{200_1}, le chauffage permet une augmentation de la température avec un abaissement concomitant du degré d'humidité ; lorsque la température T₂₀₀ est élevée, il n'est pas raisonnable d'utiliser un chauffage, tant parce que la température peut devenir problématique pour les appareils 205 que pour des raisons d'efficacité énergétique, et une mise en fonctionnement des ventilateurs 240 des GFC 205 permet d'améliorer les échanges entre les GFC 205 et l'air ambiant, d'augmenter la température des masses métalliques et de diminuer la différence avec le flux d'air, de façon à éviter le dépôt d'humidité sur lesdites masses.

De plus, il est souhaitable de s'adapter aux conditions externes d'utilisation pour modifier les températures de consigne lorsque les GFC 205 sont en fonctionnement : ceci permet d'optimiser le débit d'air et réduire l'encrassement des filtres 42. Le flux d'air est selon l'invention régulé ainsi en fonction de la température extérieure Tₑₓₜ et de la puissance dissipée, afin de maintenir une température de fonctionnement optimal des GFC 205 et éviter l'encrassement des filtres 42 par un débit trop élevé d'air.

Dans le mode de réalisation préféré, le compartiment de conversion de fréquence 200 comprend ainsi au moins un capteur d'humidité 230 et un capteur de température 260 ; de préférence, deux capteurs de chaque sorte sont présents, un sur chaque côté du compartiment 200 et la moyenne des deux valeurs permet de donner la température interne au compartiment T₂₀₀ et le taux d'humidité présente HR₂₀₀. La régulation de la température est assurée par un automate qui peut être le même que celui utilisé pour la régulation des compartiments des transformateurs 105 et commun à tout le poste 10, ou qui peut être dédié au compartiment de conversion de fréquence 200, dans lequel il peut aussi être logé au sein d'un coffret auxiliaire ; l'automate impose la vitesse de l'extracteur 250 par l'intermédiaire d'un bus de communication (par exemple MODBUS) et le démarrage et l'arrêt des ventilateurs 240 lorsque les GFC 205 sont à l'arrêt ; avantageusement, chaque dispositif d'extraction 250 est actionné à la même vitesse.

L'automate de régulation comprend par ailleurs de préférence également des moyens pour commander le chauffage 220, par exemple par l'intermédiaire de contacteurs.

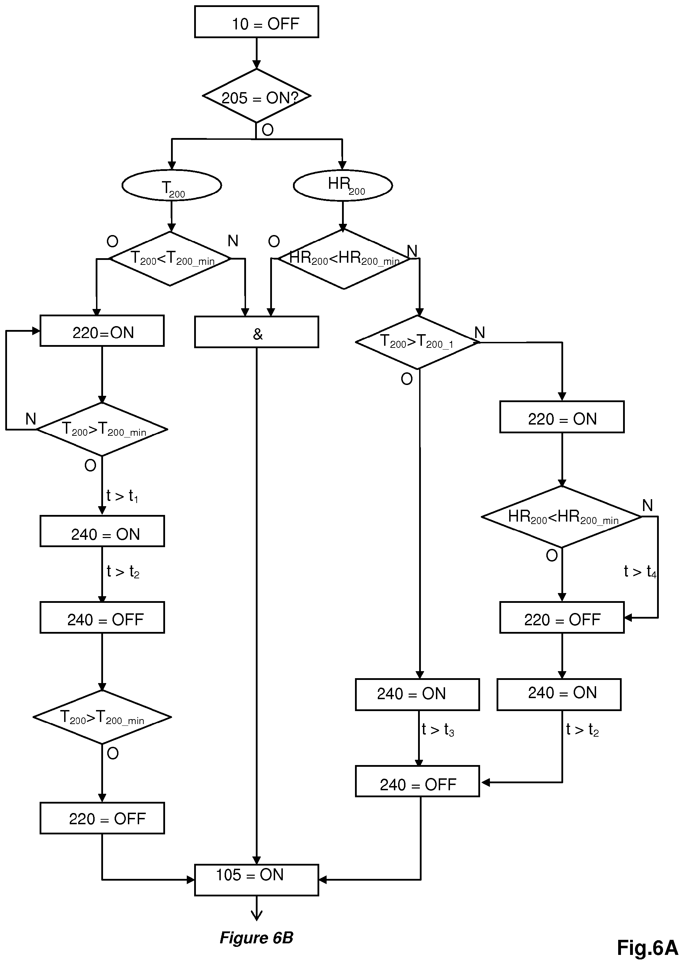

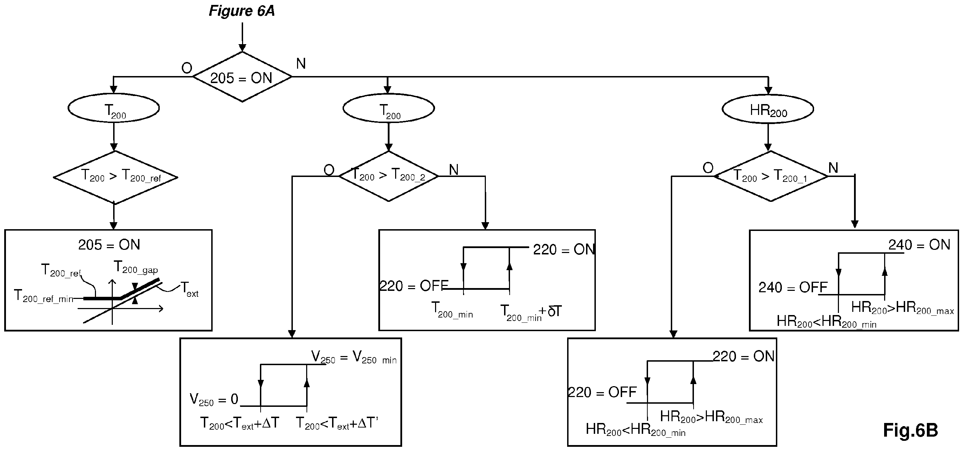

Le système de régulation permet ainsi l'ajustement de la température et de l'humidité avec plusieurs modes de fonctionnement pour s'adapter en permanence aux conditions d'utilisation, garantissant ainsi le fonctionnement optimum de tous les équipements. En particulier, tel que schématisé en figure 6, le procédé de régulation mis en œuvre par les moyens adaptés du compartiment comprend une première phase (figure 6A) de vérification des conditions environnementales alors que la conversion de fréquence n'est pas mise en œuvre, c'est-à-dire que les GFC 205 sont encore à l'arrêt. Tant que les conditions ne sont pas vérifiées, c'est-à-dire que la température T₂₀₀ n'atteint pas le seuil critique T_{200_min} classiquement de 5°C, et que le taux d'humidité HR₂₀₀ n'est pas inférieur à un seuil HR_{200_min}, classiquement de 75 %, les GFC 205 ne peuvent être mis en route et restent sur OFF ; dans le cas contraire, ils peuvent soit être démarrés, soit rester arrêtés.

La vérification des conditions environnementales peut ainsi s'accompagner d'un préchauffage pour remplir les critères ci-dessus. En particulier, si la température est inférieure à T_{200_min}, le chauffage 220 est mis en route. La température est mesurée régulièrement. Une fois qu'elle dépasse T_{200_min} = 5°C, et après un temps d'attente t₁ nécessaire pour s'assurer que l'eau présente dans les caloducs n'est plus gelée, notamment t₁ > 60 min, les ventilateurs 240 de GFC sont mis en route pendant une durée prédéterminée t₂ pour que les GFC soit bons pour le fonctionnement, par exemple 15 min. Ensuite, les ventilateurs 240 sont arrêtés, puis le chauffage 220 également : les conditions environnementales sont remplies.

Si la température mesurée au départ du processus de contrôle est supérieure à T_{200_min} = 5°C, alors le taux d'humidité HR₂₀₀ est pris en compte. S'il est inférieur à la valeur limite HR_{200_min} = 75 %, les conditions environnementales sont remplies. S'il est supérieur, alors la température du compartiment T₂₀₀ est comparée à un deuxième seuil T_{200_1}, par exemple 15°C, pour déterminer la façon dont le taux d'humidité sera abaissé. Si le deuxième seuil T_{200_1} est dépassé, alors la condensation est évitée par actionnement pendant une durée prédéfinie t₃, notamment de 15 min, des ventilateurs 240. Si le deuxième seuil T_{200_1} n'est pas atteint, alors le dispositif de chauffage 220 est mis en œuvre ; une fois que le taux d'humidité passe sous le seuil préconisé HR_{200_min}, et après un temps d'attente t₄ nécessaire pour s'assurer de l'évaporation de toute eau éventuelle, notamment t₄ > 30 min, le chauffage 220 est arrêté, puis les ventilateurs 240 de GFC sont mis en route pendant une durée prédéterminée t₂ pour que les GFC soit bons pour le fonctionnement, par exemple 15 min : les conditions environnementales sont alors remplies et les GFC 205 peuvent être mis en fonctionnement.

De fait, un GFC 205 peut fonctionner entre 0°C (si l'eau n'est pas gelée) et 45°C, sous un taux d'humidité atteignant 95 % (s'il n'y a pas déjà de condensation). Lorsque les conditions environnementales sont remplies, le GFC peut donc être mis en route immédiatement. Dans ce cas, une régulation de la température est mise en œuvre, en particulier grâce aux extracteurs 250 d'air : la température interne T₂₀₀ est contrôlée, et les extracteurs sont mis en œuvre dès qu'une valeur de température T_{200_ref} est dépassée, avec dans ce cas de préférence une loi linéaire augmentant la vitesse d'extraction avec la température (voir figure 6B) ; bien que lorsque les GFC 205 sont en marche, la condensation ne puisse se produire au vu de la chaleur dégagée, il serait possible de prendre également en compte le paramètre « degré d'humidité » HR. De façon similaire au compartiment de transformateur 100, le débit d'air peut ainsi être réglé au strict nécessaire grâce au capteur de sortie 260 situé dans le flux d'air, ce qui permet de diminuer l'encrassement des filtres 42. Si le poste d'alimentation 10 possède des moyens de mesure de la température extérieure 60, selon une option préférée de réalisation, le seuil T_{200_ref} est ajusté par en fonction de la température extérieure Tₑₓₜ. Par exemple T_{200_ref} est égal à Tₑₓₜ + T_{200_gap} mais T_{200_ref} ne pouvant pas être inférieur à T_{200_ref_min} ».

Si les GFC 205 ne sont pas démarrés, une régulation est mise en place pour permettre un démarrage à la demande, en maintenant des conditions acceptables de démarrage des GFC 205. En particulier, la température T₂₀₀ est contrôlée par l'intermédiaire des extracteurs 250 ou du chauffage 220 selon son niveau : si une température minimale T_{200_min} = 5°C n'est pas atteinte, le chauffage 220 est actionné, puis arrêté au-delà d'une température légèrement supérieure T_{200_min} + δ T, par exemple 8°C, pour tenir compte de l'inertie thermique ; si la température intérieure T₂₀₀ dépasse T_{200_2}, par exemple 25°C, alors la température intérieure au compartiment 200 est maintenue dans une gamme de température proche de la température externe Tₑₓₜ, par exemple [Tₑₓₜ + ΔT; Tₑₓₜ + ΔT'], avec par exemple ΔT = 2°C et ΔT' = 5°C, par actionnement de l'extracteur 250 à vitesse minimale V_{250_min}. Le taux d'humidité HR₂₀₀ est quant à lui contrôlé par le chauffage 220 ou les ventilateurs internes 240 en fonction de la même température interne T₂₀₀ dans un processus similaire à celui de vérification des conditions environnementales P1. Notamment, si la température est inférieure à T_{200_1} par exemple 15°, le chauffage 220 est actionné pour diminuer le taux d'humidité en dessous de HR_{200_max}, par exemple 85 % et arrêté à un taux d'humidité de l'ordre de HR_{200_min}, par exemple 75 % ; si la température dépasse 15°C, ce sont les ventilateurs 240 qui sont mis en rotation à vitesse minimale V_{240_min} avec les mêmes paramètres. Il est à noter que l'on peut passer d'un des modes à l'autre en fonction des changements de température, occasionnés par le maintien du taux d'humidité HR₂₀₀ ou par une modification des conditions climatiques externes Tₑₓₜ, HRₑₓₜ.

Ainsi, grâce au choix selon l'invention d'utiliser une ventilation forcée régulée pour les différents compartiments de conversion d'un poste d'alimentation portuaire 10, il est possible d'obtenir une solution compacte de réalimentation des bateaux à quai testée selon la norme des postes préfabriqués CEI 62271-202, dans laquelle la filtration de l'air permet de garantir une durée de vie accrue du transformateur et des convertisseurs de fréquence sous des conditions optimales d'exploitation. Notamment, il est possible de mettre en place des transformateurs secs de 3 MVA dans des compartiments non climatisés de 8 m² sur 3 m, de hauteur, c'est-à-dire dont les dimensions ne permettent pas d'appliquer les recommandations habituelles pour le refroidissement des transformateurs 105, tout en allongeant la durée de vie du transformateur par rapport à un fonctionnement nominal externe sous ventilation naturelle. De plus, le poste 10 peut répondre aux critères de l'IP44 pour garantir le bon fonctionnement dans un environnement sévère, ceci avec un coût réduit, déjà parce que les transformateurs 105 peuvent être de puissance inférieure et de constitution classique malgré les conditions d'usage, mais aussi par un allongement de la durée de vie des composants, transformateurs 105 ou GFC 205 qui ne subissent pas de vieillissement accéléré puisqu'ils sont utilisés dans des conditions « normales », ainsi que filtres 42 qui peuvent être changés moins souvent grâce à la régulation du flux d'air entrant. Par ailleurs, l'énergie consommée pour contrôler par exemple la condensation au niveau des GFC 205 est réduite.

La régulation elle-même est une solution robuste adaptée aux contraintes particulières de l'application, avec une variation très rapide de la puissance dissipée et une constante de temps très faible, contraintes inhérentes aux appels de charge à bord des navires alimentés. Les conditions optimales générées par ce système à l'intérieur des compartiments 100, 200 augmentent en outre la fiabilité des appareils électriques 105, 205 et du poste 10 en général, ainsi que sa disponibilité.

Bien que l'invention ait été décrite en référence à un poste 3 MVA d'alimentation portuaire à enceinte métallique, elle ne s'y limite pas : d'autres postes peuvent être concernés par l'invention. En particulier des postes d'alimentation portuaire en béton, et/ou de puissance inférieure ne contenant qu'un seul transformateur de puissance.

## Revendications

1. Poste d'alimentation électrique portuaire (10) comprenant une enceinte métallique (30) dans laquelle sont logés un premier compartiment (100) comprenant un transformateur de tension et un compartiment de conversion de fréquence (200), le poste comprenant un deuxième compartiment (100') comprenant un transformateur de tension, l'enceinte logeant les trois compartiments (100, 200, 100') séparés entre eux par des parois internes, le compartiment de conversion de fréquence (200) étant encadré par le premier et le deuxième compartiment (100, 100'), le compartiment de conversion de fréquence (200) comprenant :
- des moyens d'entrée d'air (40) localisés sur une partie d'extrémité basse de l'enceinte (30) et dotés d'au moins un filtre (42) ;
- des moyens de sortie d'air (50) localisés sur une partie d'extrémité haute de l'enceinte (30) ;
- un dispositif de ventilation pour faire circuler l'air dans l'enceinte (30) comprenant des moyens d'extraction (250) associés aux moyens de sortie d'air (50) et au moins un ventilateur (240) associé aux moyens de conversion de fréquence (205) ;
- un dispositif de chauffage (220) ;
- des premiers moyens (165, 260) pour mesurer la température (T100, T200) dans l'enceinte (30) localisés au niveau des moyens de sortie d'air (50) ;
- des moyens pour vérifier les conditions environnementales à l'intérieur de l'enceinte (30) et pour démarrer les moyens de conversion de fréquence (205) lorsque les conditions environnementales sont remplies, la vérification des conditions environnementales comprenant la comparaison de la température mesurée (T200) à une valeur limite (T200_min) ;
- des moyens de régulation de la température (T200) aptes à commander la vitesse des moyens d'extraction (250) et le dispositif de chauffage (220) en fonction de la température mesurée (T200).

2. Poste d'alimentation selon la revendication 1 comprenant en outre des moyens de mesure (230) du taux d'humidité dans le compartiment, et la vérification des conditions environnementales comprend la comparaison du taux d'humidité (HR200) à un taux moyen d'humidité, lesdits moyens de régulation comprennent des moyens pour mettre en route le dispositif de chauffage (220) lorsque le taux d'humidité dépasse une valeur limite d'humidité (HR200_max) et la température mesurée (T200) est inférieure à une première valeur (T200_1), et des moyens pour activer les ventilateurs (240) lorsque le taux d'humidité dépasse la valeur limite d'humidité (HR200_max) et la température mesurée (T200) est supérieure à la première valeur (T200_1).

3. Poste d'alimentation selon l'une des revendications 1 ou 2 dans lequel les moyens d'entrée d'air (40) comprennent deux caissons localisés sur deux parois opposées de l'enceinte (30) et le dispositif de ventilation comprend deux ventilateurs tangentiels (140).

4. Poste d'alimentation selon l'une des revendications précédentes dans lequel le compartiment de conversion de fréquence (200) comprend des moyens de ventilation forcée (250), et des moyens de régulation des premier et deuxième compartiments (100, 100') comprenant des moyens d'extraction (150) et des moyens pour démarrer lesdits moyens d'extraction (150) lorsque les moyens de ventilation forcée (250) du compartiment de conversion de fréquence (200) sont activés.

5. Poste d'alimentation selon la revendication précédente comprenant des moyens (60) de mesure de la température externe, et les moyens de régulation des premier et deuxième compartiments (100, 100') comprennent des moyens pour déterminer la valeur limite (T_{100_ref}) de la température mesurée dans l'enceinte (T₁₀₀) en fonction de la température externe mesurée (Tₑₓₜ).

6. Poste d'alimentation selon l'une des revendications précédentes **caractérisé en ce que** le premier et le deuxième compartiments (100, 100') comprennent :
- au moins un ventilateur tangentiel (140) situé à proximité des moyens d'entrée d'air (40) ;
- des moyens d'extraction (150) associés aux moyens de sortie d'air (50) ;
- des seconds moyens (160) pour mesurer la température (T₁₁₀) au sein du transformateur de tension (105) ;
- la mise en route des moyens d'extraction (150) et des ventilateurs tangentiels (140) en fonction de la température (T₁₀₀, T₁₁₀) mesurée par les premiers et deuxièmes moyens (160, 165) ;
dans lequel les moyens de régulation comprennent des moyens pour imposer une vitesse (V₁₅₀) fonction de la température dans l'enceinte (T₁₀₀) aux moyens d'extraction (150) lorsque ladite température (T₁₀₀) dépasse une valeur limite (T_{100_ref}).

7. Poste d'alimentation selon la revendication précédente dans lequel le transformateur (105) est un transformateur de type sec avec trois enroulements basse tension (110) et trois enroulements moyenne tension, et les seconds moyens comprennent trois capteurs de température (160) associés à chacun des enroulements basse tension (110), les moyens de régulation comprenant des moyens pour démarrer les ventilateurs tangentiels (140) lorsque la température (T₁₁₀) mesurée par l'un des trois capteurs (160) dépasse un premier seuil (T_{110_1}).

8. Poste d'alimentation selon la revendication 7 dans lequel les moyens de régulation comprennent des moyens pour arrêter les ventilateurs (140) lorsque les trois capteurs de température (160) donnent une valeur de température inférieure à un deuxième seuil (T_{110_0}) et si la température (T₁₁₀) mesurée par l'un des trois capteurs (160) est inférieure à une valeur d'alerte (T_{110_max}).

9. Procédé de régulation de la température d'un compartiment (200) d'un poste d'alimentation portuaire (10) selon la revendication 1 comprenant une enceinte (30) munie d'une entrée d'air (40), d'une sortie d'air (50) associée à des moyens d'extraction (250), et logeant au moins un appareil de conversion de fréquence (205) associé à un ventilateur (240), ledit procédé comprenant :
- la mise en route des appareils de conversion (205) ;
- la mesure de la température (T₂₀₀) interne au compartiment (200) ;
- l'actionnement de l'extraction d'air lorsque la température est supérieure à une valeur limite (T_{200_ref}), la vitesse de l'extraction (V₂₅₀) dépendant de la température interne (T₂₀₀).

10. Procédé de régulation selon la revendication 9 dans lequel la mise en route des appareils de conversion (205) est précédée d'une phase de vérification des conditions environnementales comprenant :
- la mesure de la température interne (T₂₀₀) au compartiment (200) et le chauffage dudit compartiment (200) tant que la température mesurée est inférieure à un seuil critique (T_{200_min}), le chauffage étant maintenu au moins une première durée (t₁) après que la température a atteint ledit seuil (T_{100_min}) ;
- la détermination du taux d'humidité (HR₂₀₀) interne au compartiment et la mise en œuvre de moyens de diminution du taux en dessous d'un seuil (HR_{200_min}), les moyens de mise en œuvre de la diminution étant maintenus pendant au moins une deuxième durée (t₃) après que le seuil (HR_{200_min}) a été atteint ;
- la mise en route des ventilateurs (240) une fois les conditions remplies ;
- l'arrêt des ventilateurs (240) après une troisième durée (t₂).

11. Procédé de régulation selon la revendication 10 comprenant, après la vérification des conditions environnementales et avant la mise en route des appareils de conversion (205), des étapes de maintien des conditions environnementales comprenant :
- le maintien de la température interne (T₂₀₀) au dessus de la valeur critique (T_{200_min}) ;
- le maintien du taux d'humidité (HR₂₀₀) au dessous d'une valeur critique (HR_{200_min}), ledit maintien étant réalisé par actionnement des ventilateurs (240) ou chauffage (220) selon la température interne (T₂₀₀).

12. Procédé de régulation selon la revendication 11 dans lequel les étapes de maintien comprennent en outre le maintien de la température interne dans un intervalle prédéterminé autour de la température externe (Tₑₓₜ) lorsque la température interne est au-dessus d'une valeur supérieure (T_{200_2}) par mise en route de l'extraction d'air.

## Patentansprüche

1. Stromversorgungsanlage in einem Hafen (10), welche ein metallisches Gehäuse (30) umfasst, in welchem ein erstes Abteil (100), das einen Spannungswandler umfasst, und ein Frequenzumwandlungs-Abteil (200) untergebracht sind, wobei die Anlage ein zweites Abteil (100') umfasst, das einen Spannungswandler umfasst, wobei das Gehäuse die drei Abteile (100, 200, 100') auf eine solche Weise aufnimmt, dass diese durch Innenwände voneinander getrennt sind, wobei das Frequenzumwandlungs-Abteil (200) von dem ersten und dem zweiten Abteil (100, 100') eingerahmt wird, wobei das Frequenzumwandlungs-Abteil (200) umfasst:
- Lufteintrittsmittel (40), die an einem unteren Endteil des Gehäuses (30) angeordnet sind und mit wenigstens einem Filter (42) ausgestattet sind;
- Luftaustrittsmittel (50), die an einem oberen Endteil des Gehäuses (30) angeordnet sind;
- eine Lüftungsvorrichtung zum Umwälzen der Luft im Gehäuse (30), welche Absaugmittel (250), die den Luftaustrittsmitteln (50) zugeordnet sind, und wenigstens einen Ventilator (240), der den Frequenzumwandlungsmitteln (205) zugeordnet ist, umfasst;
- eine Heizvorrichtung (220);
- erste Mittel (165, 260) zum Messen der Temperatur (T100, T200) im Gehäuse (30), die bei den Luftaustrittsmitteln (50) angeordnet sind;
- Mittel zum Überprüfen der Umgebungsbedingungen im Inneren des Gehäuses (30) und zum Starten der Frequenzumwandlungsmittel (205), wenn die Umgebungsbedingungen erfüllt sind, wobei die Überprüfung der Umgebungsbedingungen den Vergleich der gemessenen Temperatur (T200) mit einem Grenzwert (T200_min) umfasst;
- Mittel zur Regulierung der Temperatur (T200), die in der Lage sind, die Geschwindigkeit der Absaugmittel (250) und die Heizvorrichtung (220) in Abhängigkeit von der gemessenen Temperatur (T200) zu steuern.

2. Stromversorgungsanlage nach Anspruch 1, welche außerdem Mittel zur Messung (230) des Feuchtigkeitsgehalts in dem Abteil umfasst, und wobei die Überprüfung der Umgebungsbedingungen den Vergleich des Feuchtigkeitsgehalts (HR200) mit einem mittleren Feuchtigkeitsgehalt umfasst und die Mittel zur Regulierung Mittel zur Ingangsetzung der Heizvorrichtung (220), wenn der Feuchtigkeitsgehalt einen Feuchtigkeitsgrenzwert (HR200_max) überschreitet und die gemessene Temperatur (T200) niedriger als ein erster Wert (T200_1) ist, und Mittel zum Aktivieren der Ventilatoren (240), wenn der Feuchtigkeitsgehalt den Feuchtigkeitsgrenzwert (HR200_max) überschreitet und die gemessene Temperatur (T200) höher als der erste Wert (T200_1) ist, umfassen.

3. Stromversorgungsanlage nach einem der Ansprüche 1 oder 2, wobei die Lufteintrittsmittel (40) zwei Kassetten umfassen, die an zwei gegenüberliegenden Wänden des Gehäuses (30) angeordnet sind, und die Lüftungsvorrichtung zwei Tangentialventilatoren (140) umfasst.

4. Stromversorgungsanlage nach einem der vorhergehenden Ansprüche, wobei das Frequenzumwandlungs-Abteil (200) Mittel zur Fremdbelüftung (250) umfasst und Mittel zur Regulierung des ersten und zweiten Abteils (100, 100') Absaugmittel (150) und Mittel zum Starten der Absaugmittel (150), wenn die Mittel zur Fremdbelüftung (250) des Frequenzumwandlungs-Abteils (200) aktiviert sind, umfassen.

5. Stromversorgungsanlage nach dem vorhergehenden Anspruch, welche Mittel (60) zur Messung der Außentemperatur umfasst, und wobei die Mittel zur Regulierung des ersten und zweiten Abteils (100, 100') Mittel zum Bestimmen des Grenzwertes (T_{100_ref}) der gemessenen Temperatur im Gehäuse (T₁₀₀) in Abhängigkeit von der gemessenen Außentemperatur (Tₑₓₜ) umfassen.

6. Stromversorgungsanlage nach einem der vorhergehenden Ansprüche, **dadurch gekennzeichnet, dass** das erste und das zweite Abteil (100, 100') umfassen:
- wenigstens einen Tangentialventilator (140), der sich in der Nähe der Lufteintrittsmittel (40) befindet;
- Absaugmittel (150), die den Luftaustrittsmitteln (50) zugeordnet sind;
- zweite Mittel (160) zum Messen der Temperatur (T₁₁₀) im Inneren des Spannungswandlers (105);
- die Ingangsetzung der Absaugmittel (150) und der Tangentialventilatoren (140) in Abhängigkeit von der Temperatur (T₁₀₀, T₁₁₀), die von den ersten und zweiten Mitteln (160, 165) gemessen wird;
wobei die Mittel zur Regulierung Mittel zum Vorschreiben einer Geschwindigkeit (V₁₅₀), die von der Temperatur im Gehäuse (T₁₀₀) abhängt, für die Absaugmittel (150), wenn die Temperatur (T₁₀₀) einen Grenzwert (T_{100_ref}) überschreitet, umfassen.

7. Stromversorgungsanlage nach dem vorhergehenden Anspruch, wobei der Wandler (105) ein Transformator vom Typ eines Trockentransformators mit drei Niederspannungswicklungen (110) und drei Mittelspannungswicklungen ist und die zweiten Mittel drei Temperatursensoren (160) umfassen, die jeweils einer der Niederspannungswicklungen (110) zugeordnet sind, wobei die Mittel zur Regulierung Mittel zum Starten der Tangentialventilatoren (140), wenn die von einem der drei Sensoren (160) gemessene Temperatur (T₁₁₀) einen ersten Schwellenwert (T_{110_1}) überschreitet, umfassen.

8. Stromversorgungsanlage nach Anspruch 7, wobei die Mittel zur Regulierung Mittel zum Abschalten der Ventilatoren (140), wenn die drei Temperatursensoren (160) einen Temperaturwert liefern, der niedriger als ein zweiter Schwellenwert (T_{110_0}) ist, und falls die von einem der drei Sensoren (160) gemessene Temperatur (T₁₁₀) niedriger als ein Alarmwert (T_{110_max}) ist, umfassen.

9. Verfahren zur Regulierung der Temperatur eines Abteils (200) einer Stromversorgungsanlage in einem Hafen (10) nach Anspruch 1, welche ein Gehäuse (30) umfasst, das mit einem Lufteintritt (40) und einem Luftaustritt (50), der Absaugmitteln (250) zugeordnet ist, versehen ist und wenigstens eine Frequenzumwandlungsvorrichtung (205) aufnimmt, die einem Ventilator (240) zugeordnet ist, wobei das Verfahren umfasst:
- die Ingangsetzung der Umwandlungsvorrichtungen (205);
- die Messung der Innentemperatur (T₂₀₀) des Abteils (200);
- die Betätigung der Luftabsaugung, wenn die Temperatur höher als ein Grenzwert (T_{200_ref}) ist, wobei die Absauggeschwindigkeit (V₂₅₀) von der Innentemperatur (T₂₀₀) abhängt.

10. Verfahren zur Regulierung nach Anspruch 9, wobei der Ingangsetzung der Umwandlungsvorrichtungen (205) eine Phase der Überprüfung der Umgebungsbedingungen vorausgeht, welche umfasst:
- die Messung der Innentemperatur (T₂₀₀) des Abteils (200) und die Heizung des Abteils (200), solange die gemessene Temperatur niedriger als ein kritischer Schwellenwert (T_{200_min}) ist, wobei die Heizung wenigstens während einer ersten Dauer (t₁) aufrechterhalten wird, nachdem die Temperatur den Schwellenwert (T_{100_min}) erreicht hat;
- die Bestimmung des Feuchtigkeitsgehalts (HR₂₀₀) im Inneren des Abteils und den Einsatz von Mitteln zur Verringerung des Feuchtigkeitsgehalts unter einen Schwellenwert (HR_{200_min}), wobei die Mittel zur Durchführung der Verringerung während wenigstens einer zweiten Dauer (t₃) weiterbetrieben werden, nachdem der Schwellenwert (HR_{200_min}) erreicht worden ist;
- die Ingangsetzung der Ventilatoren (240), nachdem die Bedingungen erfüllt sind;
- die Abschaltung der Ventilatoren (240) nach einer dritten Dauer (t₂).

11. Verfahren zur Regulierung nach Anspruch 10, welches nach der Überprüfung der Umgebungsbedingungen und vor der Ingangsetzung der Umwandlungsvorrichtungen (205) Schritte der Aufrechterhaltung der Umgebungsbedingungen umfasst, welche umfassen:
- das Halten der Innentemperatur (T₂₀₀) oberhalb des kritischen Wertes (T_{200_min});
- das Halten des Feuchtigkeitsgehalts (HR₂₀₀) unterhalb eines kritischen Wertes (HR_{200_min}), wobei das Halten durch Betätigung der Ventilatoren (240) oder der Heizung (220) je nach der Innentemperatur (T₂₀₀) realisiert wird.

12. Verfahren zur Regulierung nach Anspruch 11, wobei die Schritte der Aufrechterhaltung außerdem das Halten der Innentemperatur in einem vorbestimmten Intervall um die Außentemperatur (Tₑₓₜ), wenn die Innentemperatur oberhalb eines oberen Wertes (T_{200_2}) liegt, durch Ingangsetzung der Luftabsetzung umfassen.

## Claims

1. Port electrical power supply substation (10) comprising a metal enclosure (30) housing a first compartment (100) comprising a voltage transformer and a frequency-conversion compartment (200), **characterized in that** the substation comprises a second compartment (100') comprising a voltage transformer, the enclosure housing the three compartments (100, 200, 100') which are separated from one another by internal partitions, the frequency-conversion compartment (200) being flanked by the first and the second compartment (100, 100'), the frequency-conversion compartment (200) comprising:
- air inlet means (40) located on a bottom end part of the enclosure (30) and provided with at least one filter (42);
- air outlet means (50) located on a top end part of the enclosure (30);
- a ventilation device for causing the air to circulate in the enclosure (30) and comprising extraction means (250) associated with the air outlet means (50) and at least one fan (240) associated with the frequency-conversion means (205);
- a heating device (220);
- first means (165, 260) for measuring the temperature (T100, T200) in the enclosure (30) and located in the region of the air outlet means (50);
- means for checking the environmental conditions inside the enclosure (30) and for starting the frequency-conversion means (205) when the environmental conditions are met, the checking of the environmental conditions including comparing the measured temperature (T200) against a limit value (T200_min);
- means for regulating the temperature (T200) and able to control the speed of the extraction means (250) and the heating device (220) according to the measured temperature (T200).

2. Power supply substation according to Claim 1, further comprising means (230) for measuring the humidity in the compartment, and the checking of the environmental conditions includes comparing the humidity (HR200) against a mean humidity, the said regulating means comprise means for starting the heating device (220) when the humidity exceeds a limit humidity value (HR200_max) and the measured temperature (T200) is below a first value (T200_1), and means for activating the fans (240) when the humidity exceeds the limit humidity value (HR200_max) and the measured temperature (T200) is above the first value (T200_1).

3. Power supply substation according to one of Claims 1 and 2, in which the air inlet means (40) comprise two casings located on two opposite walls of the enclosure (30) and the ventilation device comprises two tangential fans (140).

4. Power supply substation according to one of the preceding claims, in which the frequency-conversion compartment (200) comprises forced-ventilation means (250), and means for regulating the first and second compartments (100, 100') comprising extraction means (150) and means for starting the said extraction means (150) when the means (250) for the forced ventilation of the frequency-conversion compartment (200) are activated.

5. Power supply substation according to the preceding claim, comprising means (60) for measuring the external temperature, and the means for regulating the first and second compartments (100, 100') comprise means for determining the limit value (T_{100_ref}) for the temperature measured in the enclosure (T₁₀₀) as a function of the measured external temperature (Tₑₓₜ).

6. Power supply substation according to one of the preceding claims, **characterized in that** the first and second compartments (100, 100') comprise:
- at least one tangential fan (140) situated close to the air inlet means (40);
- extraction means (150) associated with the air outlet means (50);
- second means (160) for measuring the temperature (T₁₁₀) within the voltage transformer (105);
- the starting of the extraction means (150) and of the tangential fans (140) on the basis of the temperature (T₁₀₀, T₁₁₀) measured by the first and second means (160, 165);
in which the regulating means comprise means for imposing a speed (V₁₅₀) dependent on the temperature in the enclosure (T₁₀₀) on the extraction means (150) when the said temperature (T₁₀₀) exceeds a limit value (T_{100_ref}).

7. Power supply substation according to the preceding claim, in which the transformer (105) is a transformer of the dry type with three low-voltage windings (110) and three medium-voltage windings, and the second means comprise three temperature sensors (160) associated with each of the low-voltage windings (110), the regulating means comprising means for starting the tangential fans (140) when the temperature (T₁₁₀) measured by one of the three sensors (160) exceeds a first threshold (T_{110_1}).

8. Power supply substation according to Claim 7, in which the regulating means comprise means for stopping the fans (140) when the three temperature sensors (160) give a temperature value below a second threshold (T_{110_0}) and if the temperature (T₁₁₀) measured by one of the three sensors (160) is below a warning value (T_{110_max}).

9. Method for regulating the temperature of a compartment (200) of a port power supply substation (10) according to Claim 1, comprising an enclosure (30) equipped with an air inlet (40) and with an air outlet (50) associated with extraction means (250), and housing at least one frequency-conversion unit (205) associated with a fan (240), the said method comprising:
- starting the conversion units (205);
- measuring the temperature (T₂₀₀) internal to the compartment (200);
- actuating air extraction when the temperature is above a limit value (T_{200_ref}), the extraction speed (V₂₅₀) being dependent on the internal temperature (T₂₀₀).

10. Regulating method according to Claim 9, in which the starting of the conversion units (205) is preceded by a phase of checking the environmental conditions, comprising:
- measuring the temperature (T₂₀₀) internal to the compartment (200) and heating the said compartment (200) as long as the measured temperature is below a critical threshold (T_{200_min}), the heating being maintained for at least a first duration (t₁) after the temperature has reached the said threshold (T_{100_min});
- determining the humidity (HR₂₀₀) internal to the compartment and operating means for reducing the humidity to below a threshold (HR_{200_min}), the means for performing the reduction being kept in operation for at least a second duration (t₃) after the threshold (HR_{200_min}) has been reached;
- starting the fans (240) once the conditions have been met;
- stopping the fans (240) after a third duration (t₂).

11. Regulating method according to Claim 10, comprising, after the checking of the environmental conditions and before the starting of the conversion units (205), steps of maintaining the environmental conditions, comprising:
- keeping the internal temperature (T₂₀₀) above the critical value (T_{200_min});
- keeping the humidity (HR₂₀₀) below a critical value (HR_{200_min}), the said maintaining of values being achieved by actuating the fans (240) or heating (220), depending on the internal temperature (T₂₀₀).

12. Regulating method according to Claim 11, in which the value-maintaining steps further include keeping the internal temperature within a predetermined interval around the external temperature (Tₑₓₜ) when the internal temperature is above an upper value (T_{200_2}) by switching on the air extraction.
